(19) Europäisches Patentamt / European Patent Office / Office européen des brevets

(11) **EP 2 192 414 A1**

(12) **EUROPEAN PATENT APPLICATION**

(43) Date of publication:
**02.06.2010 Bulletin 2010/22**

(51) Int Cl.:
***G01R 19/25*** (2006.01)

(21) Application number: **08170389.4**

(22) Date of filing: **01.12.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicants:
• **Mitsubishi Electric R&D Centre Europe B.V.
20 Frederick Sanger Road
The Surrey Research Park
Guildford, Surrey GU2 7YD (GB)**
Designated Contracting States:
**GB**
• **Mitsubishi Denki Kabushiki Kaisha
Chiyoda-ku
Tokyo, 100-8310 (JP)**
Designated Contracting States:
**AT BE BG CH CY CZ DE DK EE ES FI FR GR HR
HU IE IS IT LI LT LU LV MC MT NL NO PL PT RO
SE SI SK TR**

(72) Inventor: **Szajnowski, Dr. Wieslaw Jerzy
Guildford, Surrey GU1 2AR (GB)**

(74) Representative: **HOFFMANN EITLE
Patent- und Rechtsanwälte
Arabellastrasse 4
81925 München (DE)**

(54) **Detection of sinusoidal waveform in noise**

(57)    Signal processing method and apparatus are disclosed for detecting a signal having the form of a sine wave or its segment in the presence of noise or other interference. A received segment is processed to calculate two measures, namely a measure of the mean level of the signal and a measure of the concordance of a zero-crossing pattern of the received segment with a uniform pattern exhibited by a sinusoidal waveform having a frequency equal to the centre frequency of the signal. The calculated values of these two measures are used to define a point in a plane having axes corresponding to the measures. The position of the point is compared with a two-dimensional decision boundary in the plane which separates a region of the plane representing noise and a region of the plane representing noise plus a sinusoidal waveform. Based on the position of the point relative to the boundary, a decision is made whether the received signal contains noise alone or noise and a sinusoidal waveform.

FIG. 5

## Description

### Field of the Invention

This invention relates to signal processing for detecting a signal having the form of a sine wave or its segment in the presence of noise and other interference. The invention is especially, but not exclusively, applicable to systems intended to detect a weak sinusoidal waveform in non-Gaussian noise of impulsive nature.

### Background of the Invention

In many problems of practical interest, there is a need to detect the presence of a low-level sinusoidal waveform in background noise. For example, a physical system or phenomenon under examination may manifest its presence by producing a sinusoidal electromagnetic or ultrasonic signal.

An observed signal may originate from the system itself, when the system acts as a signal source, such as a radio transmitter. Alternatively, an observed signal may be obtained in response to some form of excitation, e.g., when, in a non-destructive testing, a suitable probing signal is scattered by a sample under investigation.

Another application in which there is a need to detect weak signals is that of robot navigation, e.g., in a noisy industrial environment. In this case, obstacle detection may be achieved by sending suitable electromagnetic or ultrasonic signals and determining the time-of-arrival of reflected echoes in the presence of noise and other interference.

In the above and other cases, it may be assumed that a segment of a received signal under examination comprises either a sinusoidal waveform corrupted by noise, or noise alone. The nominal centre frequency of the waveform may be the carrier frequency itself, or it may be some suitably chosen intermediate frequency obtained by a down-conversion process.

From a statistical viewpoint, a problem of signal detection is equivalent to selecting one of the two alternative hypotheses:

- $H_0$: noise alone present
- $H_1$: waveform present (in noise).

Consequently, the application of a detection procedure to a received signal will result in making one of two alternative decisions: "noise alone present" or "sine wave present".

One well known method of constructing useful detection procedures is based on the likelihood ratio

$$L(W) = \frac{p(W|H_1)}{p(W|H_0)} \qquad\qquad \dots\dots (1)$$

where W is some observed quantity (e.g., signal level); $p(W|H_0)$ and $p(W|H_1)$ are the conditional probability density functions of W under, respectively, hypotheses $H_0$ and $H_1$. Then, a decision "sine wave present" is made, when an observed value of W, say, $W_0$, produces the likelihood-ratio value $L(W_0)$ that will exceed some predetermined decision threshold.

In one important (Neyman-Pearson) approach to developing detection procedures, it is required to fix at some acceptable level the probability of false alarm $P_F$, defined as the probability of deciding "sine wave present" when, in fact, noise alone is present. Then, an optimum detection procedure will provide a maximum probability of detection $P_D$, defined as the probability of deciding "sine wave present", when a sine wave is present indeed in a received signal.

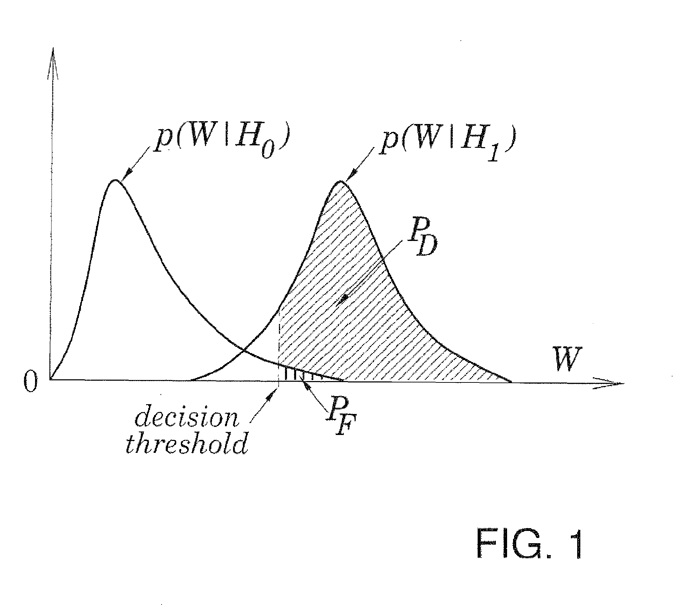

For illustrative purposes, Fig. 1 depicts two probability density functions of an observable W under the two hypotheses. As seen, a larger value of the decision threshold will result in reducing both the probability of false alarm $P_F$ and the probability of detection $P_D$,

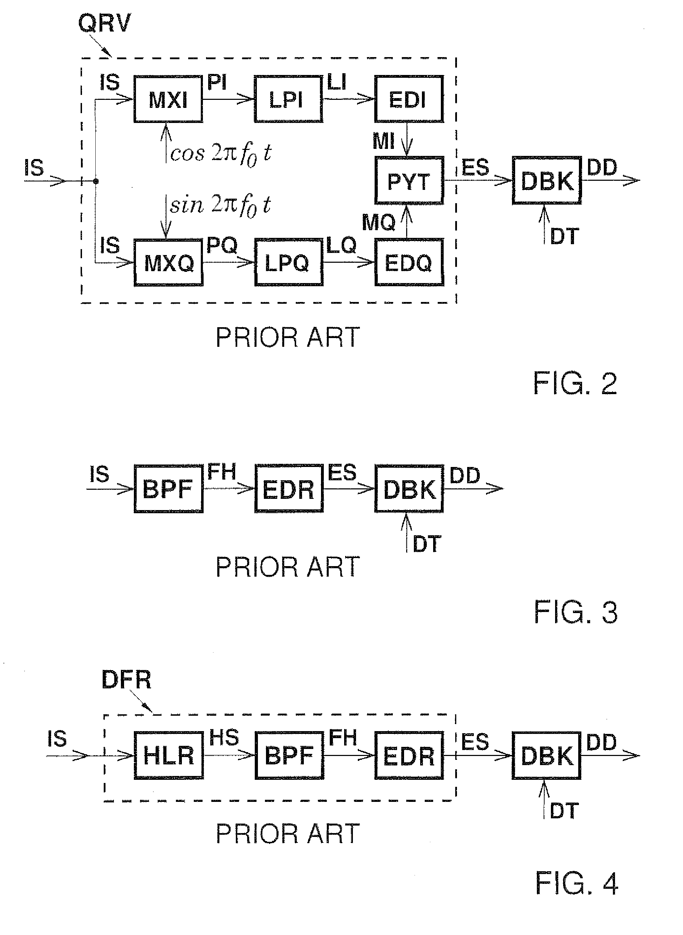

It is well known that when noise is of Gaussian nature, a good system for detecting a sine wave with known frequency $f_0$ but unknown initial phase $\phi$ is a so-called quadrature receiver QRV shown in a block form in Fig. 2. The receiver comprises the following blocks

- two mixers (or multipliers), MXI and MXQ
- two low-pass filters, LPI and LPQ
- two signal conditioning units, EDI and EDQ
- a 'Pythagoras circuit' PYT

The receiver operates as follows. An input signal IS is applied in parallel to two mixers, MXI and MXQ. The other inputs of the mixers are driven by sinusoidal and co-sinusoidal waveforms supplied by a local oscillator.

The outputs, PI and PQ, of the respective mixers are filtered in the low-pass filters LPI and LPQ to produce two output signals LI and LQ. Those two signals are first converted to suitable forms, MI and MQ, in two signal conditioning units, EDI and EDQ. Then, the 'Pythagoras circuit' PYT is employed to produce a signal ES being a representation of the quantity $\sqrt{LI^2 + LQ^2}$.

The decision block DBK compares the value ES to a decision threshold DT. Then, when the threshold has been exceeded, a decision "sine wave present" is produced at output DD.

The detection function of a quadrature receiver can also be implemented with the use of a band-pass filter followed by an envelope detector and a decision block. In a system shown in Fig. 3, an input signal IS is filtered in a band-pass filter BPF. The centre frequency of the filter is equal to the frequency of a sine wave to be detected, whereas its bandwidth is inversely proportional to the duration of a signal segment to be processed.

The output signal FH of the filter BPF is applied to an envelope detector EDR. The decision block DBK receives the envelope value ES and compares it to a decision threshold DT. Then, when the threshold has been exceeded a decision "sine wave present" is produced at output DD.

In many practical applications, background noise may comprise some combination of thermal noise and other interference, often of impulsive nature. Because it is very difficult to develop a complete statistical description of background noise, the detection of a weak sine wave in non-Gaussian noise remains one of the most challenging problems.

It is well known from prior art that an amplitude limiter followed by a band-pass filter and an envelope detector can be used in some cases to mitigate the effects of impulsive interference. Such a configuration, also known as band-pass limiter or Dicke-Fix receiver, is shown in block form in Fig. 4.

The receiver BFR comprises a hard limiter HLR, a band-pass filter BPF and an envelope detector EDR. An input signal IS is processed by the receiver DFR, and the resulting envelope value ES is applied to a decision block DBK. The block DBK compares the received value ES to a decision threshold DT. Then, when the threshold has been exceeded a decision "sine wave present" is produced at output DD.

A signal detection system that discards amplitude information is disclosed in a Patent Application: W. J. Szajnowski et al., Detection of Small Object in Bodies of Water. WO 2004/097452. 11 Nov. 2002.

The many signal detection systems disclosed in prior-art publications comprise various modifications of basic known systems and are not well suited to detecting weak sinusoidal waveforms in non-Gaussian noise. Therefore, it would be desirable to provide a method and an apparatus for improved detection of a weak sinusoidal waveform, especially in non-Gaussian noise of impulsive nature.

**Summary of the Invention**

According to the present invention, there is provided a signal processing method, comprising:

processing a received signal to calculate a first value comprising a measure of the mean level of the signal and a second value comprising a measure of the concordance of a zero-crossing pattern of the signal with a uniform pattern exhibited by a sinusoidal waveform having a frequency equal to the centre frequency of the signal;

defining a point in a two-dimensional space having coordinates determined by the calculated first and second values;

comparing the position of the point with a boundary line in the two-dimensional space; and

determining whether the received signal contains a waveform to be detected in dependence upon the result of the comparison.

The present invention also provides a signal processing apparatus, comprising:

means for processing a received signal to calculate a first value comprising a measure of the mean level of the signal and a second value comprising a measure of the concordance of a zero-crossing pattern of the signal with a uniform pattern exhibited by a sinusoidal waveform having a frequency equal to the centre frequency of the signal; and

means for determining whether a point having a position dependent upon the calculated first and second values lies in a predetermined region of space representing noise or a predetermined region of space representing noise plus a sinusoidal waveform.

**Description of the Drawings**

Fig. 1 depicts two conditional probability density functions involved in a signal detection problem.

Fig. 2 is a block diagram of a quadrature receiver known from prior art.

Fig. 3 is a block diagram of an envelope detector known from prior art.

Fig 4 is a block diagram of a band-pass limiter known from prior art.

Fig. 5 depicts schematically the procedure according to embodiments of the invention to represent a given signal segment by a value of envelope Z and a value of phase concentration R, in which:

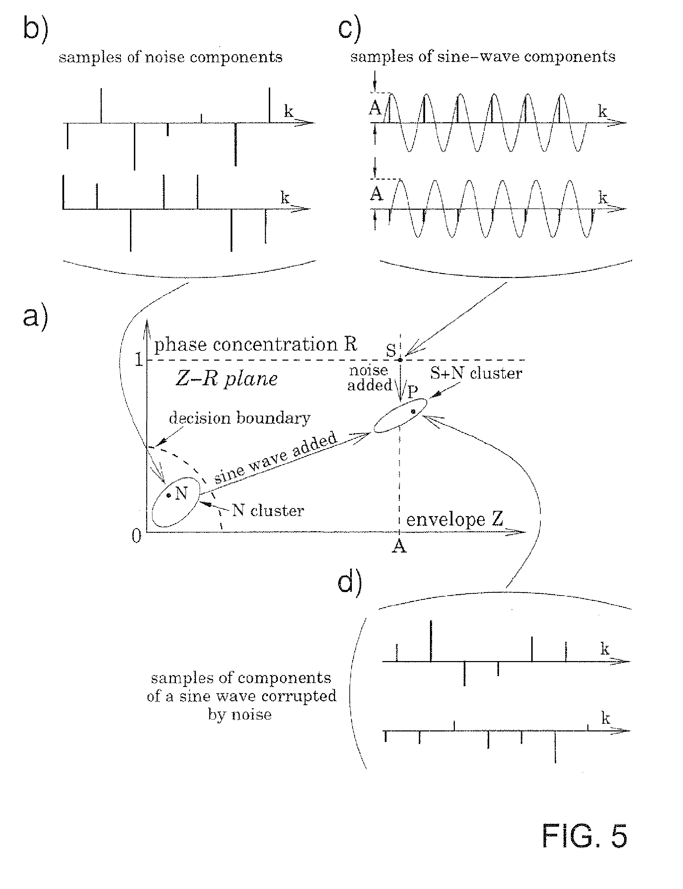

Fig. 5 a) depicts a Z-R plane, defined by two orthogonal coordinates: envelope Z and phase concentration R.

Fig. 5 b) shows samples of two quadrature components of a specific segment of noise.

Fig. 5 c) shows samples of two quadrature components of a sine-wave segment.

Fig. 5 d) shows samples of two quadrature components of a sine wave corrupted by noise.

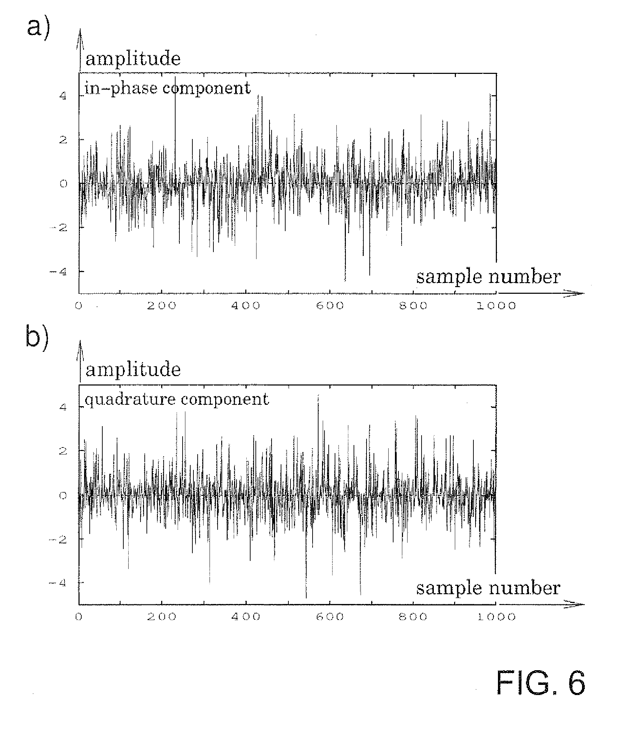

Fig. 6 a) is an example of an in-phase component of noise obtained from a Weibull envelope with shape parameter $c = 1.25$.

Fig. 6 b) is an example of a quadrature component of noise obtained from a Weibull envelope with shape parameter $c = 1.25$.

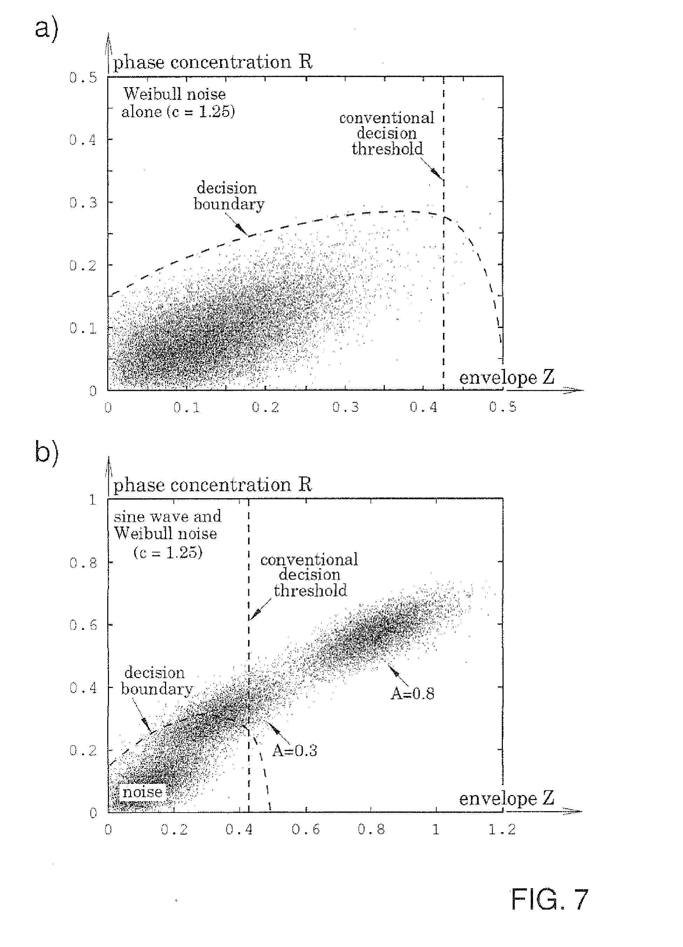

Fig. 7 a) depicts in the Z-R plane a scatter-plot of envelope Z and phase concentration R of impulsive Weibull noise with shape parameter $c = 1.25$.

Fig. 7 b) shows three scatter-plots representing, respectively: noise alone, a noisy sine wave with amplitude $A = 0.3$ and a noisy sine wave with amplitude $A = 0.8$.

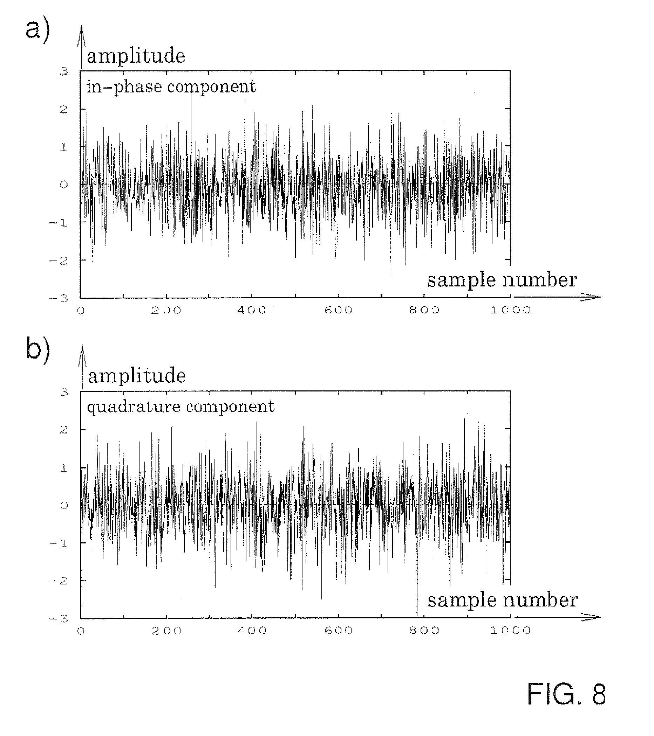

Fig. 8 a) is an example of an in-phase component of Gaussian noise obtained from a Rayleigh envelope.

Fig. 8 b) is an example of a quadrature component of Gaussian noise obtained from a Rayleigh envelope.

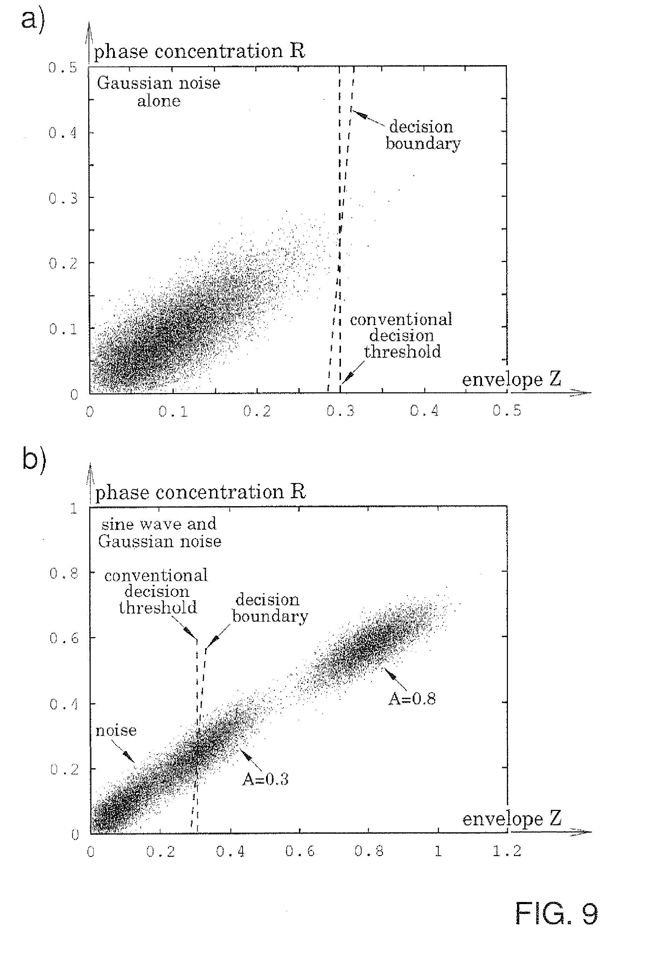

Fig. 9 a) depicts in the Z-R plane a scatter-plot of envelope Z and phase concentration R of Gaussian noise.

Fig. 9 b) shows three scatter-plots representing, respectively: Gaussian noise alone, a noisy sine wave with amplitude $A = 0.3$ and a noisy sine wave with amplitude $A = 0.8$.

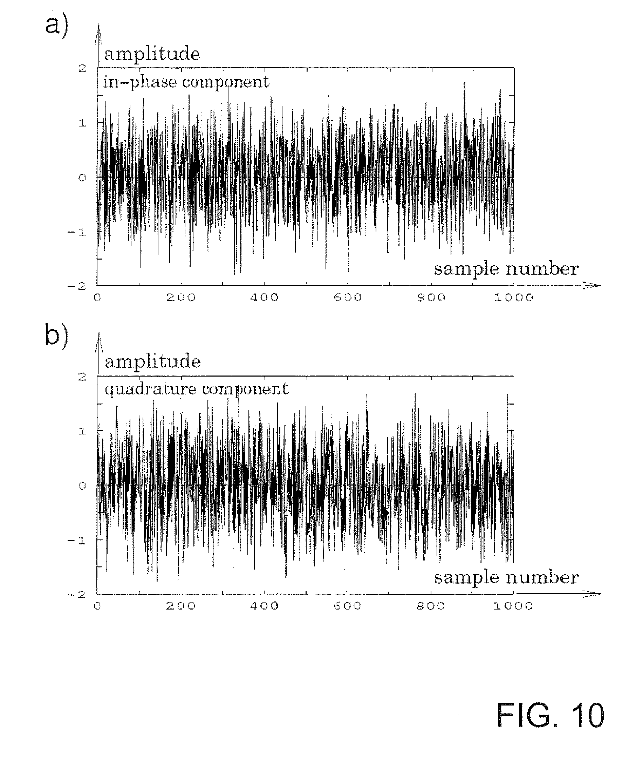

Fig. 10 a) is an example of an in-phase component of noise obtained from a Weibull envelope with shape parameter $c = 3$.

Fig. 10 b) is an example of a quadrature component of noise obtained from a Weibull envelope with shape parameter $c = 3$.

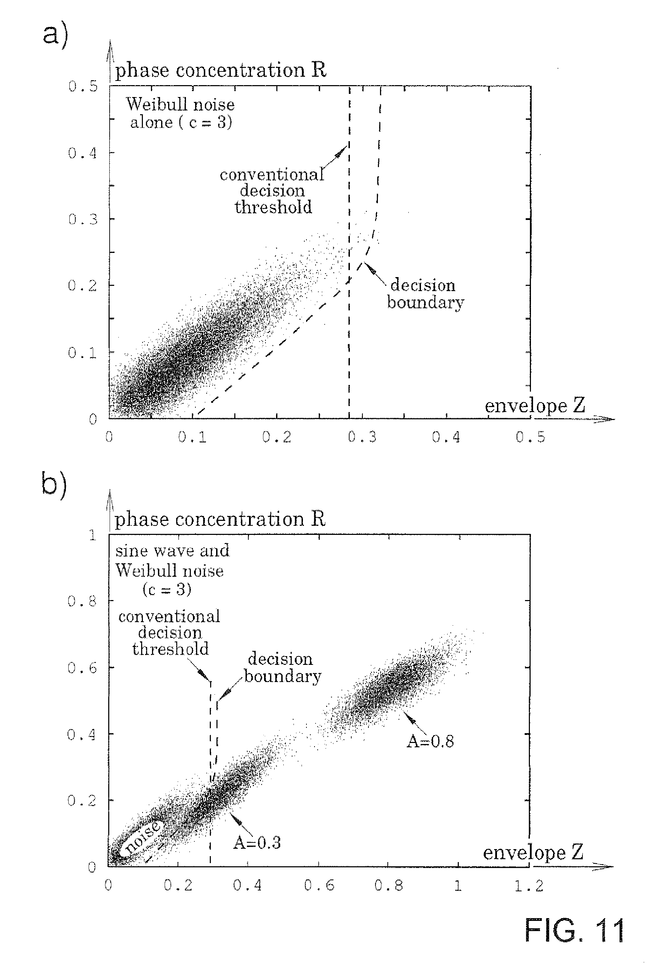

Fig. 11 a) depicts in the Z-R plane a scatter-plot of envelope Z and phase concentration R of Weibull noise with shape parameter $c = 3$.

Fig. 11 b) shows three scatter-plots representing, respectively: noise alone, a noisy sine wave with amplitude $A = 0.3$ and a noisy sine wave with amplitude $A = 0.8$.

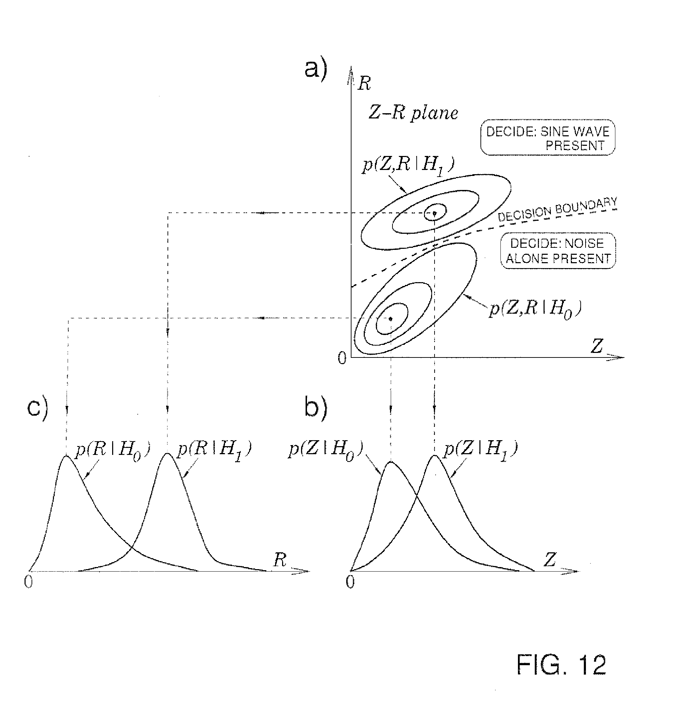

Fig. 12 a) shows examples of conditional joint probability density functions of envelope Z and phase concentration R for two cases: noise alone present and a sine wave, corrupted by noise, present.

Fig. 12 b) depicts two overlapping conditional probability density functions of envelope Z for two cases: noise alone present and a sine wave, corrupted by noise, present.

Fig. 12 c) depicts two overlapping conditional probability density functions of phase concentration R for two cases: noise alone present and a sine wave, corrupted by noise, present.

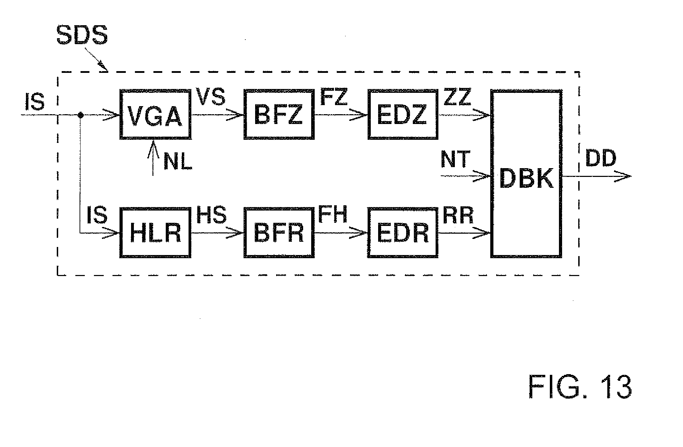

Fig. 13 is a block diagram of an analogue signal detection system comprising dual band-pass filter constructed in accordance with a first embodiment of the invention.

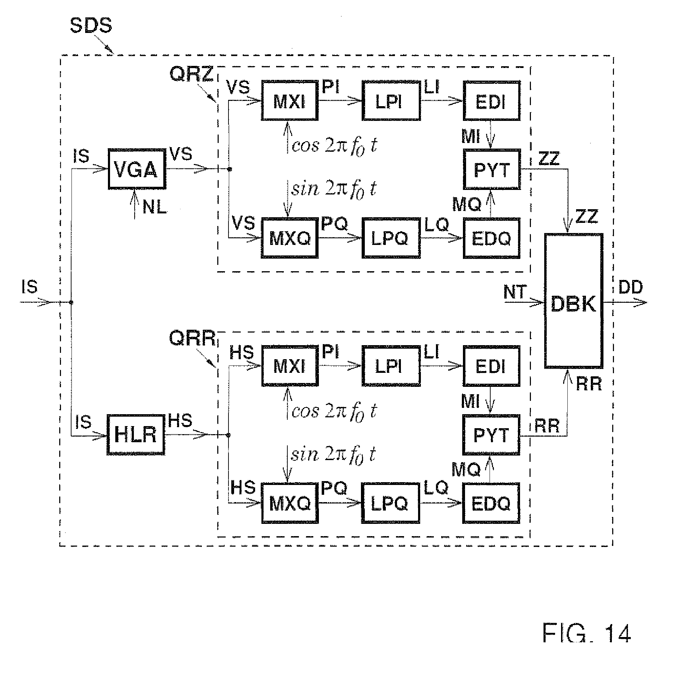

Fig. 14 is a block diagram of an analogue signal detection system comprising a dual quadrature receiver constructed in accordance with a second embodiment of the invention.

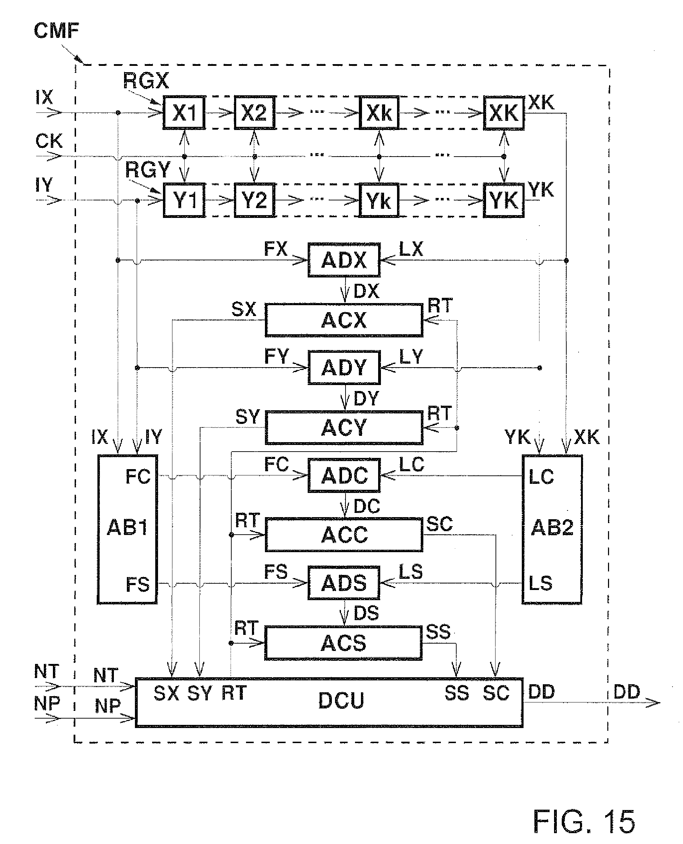

Fig. 15 is a block diagram of a digital signal detection system comprising a composite matched filter constructed in accordance with a third embodiment of the invention.

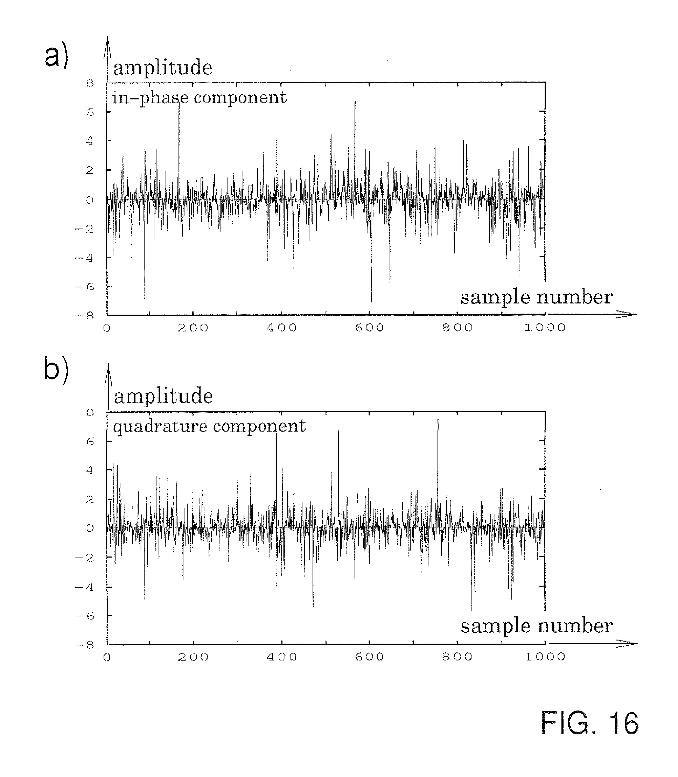

Fig. 16 a) is an example of an in-phase component of K-distributed noise with shape parameter $v = 0.5$.

Fig. 16 b) is an example of a quadrature component of K-distributed noise with shape parameter $v = 0.5$.

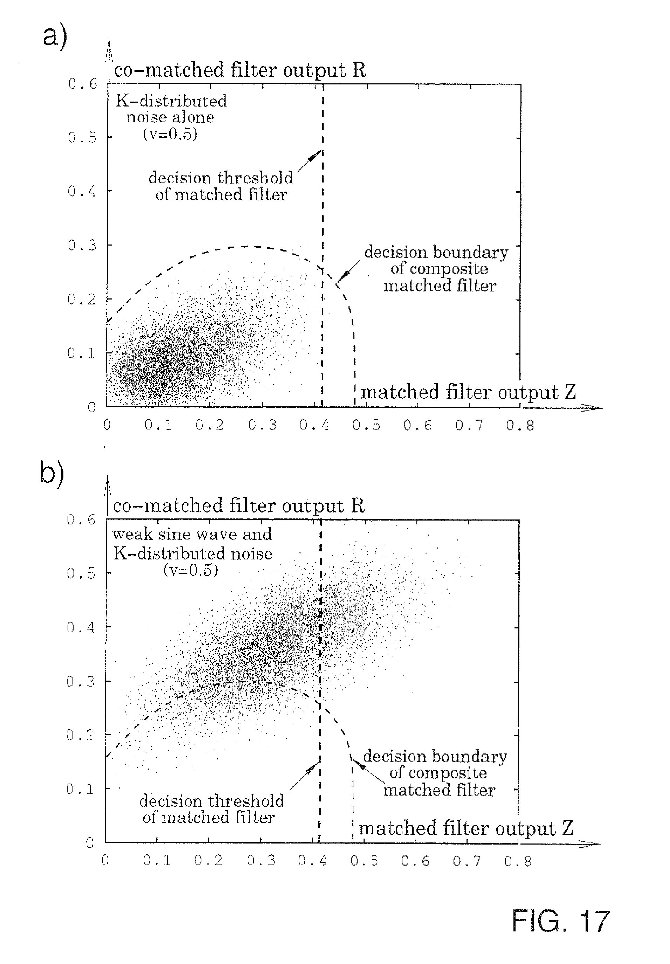

Fig. 17 a) depicts in the Z-R plane a scatter-plot of envelope Z and phase concentration R of K-distributed noise with shape parameter $v = 0.5$.

Fig. 17 b) shows a scatter-plot representing a weak sine wave with amplitude $A = 0.35$ corrupted by K-distributed noise with shape parameter $v = 0.5$.

**Embodiments**

Before describing specific embodiments of apparatus, a description of the theory underlying the processing performed by the apparatus will be given to assist understanding.

In a signal-detection problem of interest, a signal to be processed comprises either noise alone or a sine wave corrupted by noise. It is assumed that the frequency $f_0$ of a sine wave to be detected is known, and the other two parameters, amplitude A and initial phase $\phi$, are unknown. It is also assumed that the mean value of noise is equal to zero.

In accordance with embodiments of the invention, an observed segment of a received signal is characterized jointly by two parameters: a measure of the mean level of the observed segment (referred to herein as a "mean level measure") and a measure of the concordance of a zero-crossing pattern of the observed segment with a uniform (regular) pattern exhibited by a sinusoidal waveform having a frequency equal to the centre frequency of the observed segment (referred to herein as a "zero-crossing concordance measure").

One way of calculating these two measures is to calculate a phase concentration R (this being a zero-crossing concordance measure) and an envelope Z (this being a mean level measure) from two quadrature components, X(t) and Y(t), of an observed signal in the following manner. (Other ways of calculating suitable mean level measures and zero-crossing concordance measures are described in the Modifications and Variations section at the end of the description.)

Two quadrature components, X(t) and Y(t), of a received signal are sampled simultaneously at the time instants determined by a clock whose frequency is equal, or otherwise suitably related, to the frequency of a sine wave to be detected. Each sample pair, $(X_k, Y_k)$, obtained at a time instant $t_k$, k = 1,2, ... ,K, is used to calculate the following two quantities

$$\cos \theta_k = \frac{X_k}{\sqrt{X_k^2 + Y_k^2}} \quad \text{and} \quad \sin \theta_k = \frac{Y_k}{\sqrt{X_k^2 + Y_k^2}} \quad \dots \dots \ (2)$$

Then, K pairs of quantities, $(\cos\theta_k, \sin\theta_k)$, are utilized to determine the phase concentration R as:

$$R = \sqrt{\left(\frac{1}{K}\sum_{k=1}^{K}\cos\theta_k\right)^2 + \left(\frac{1}{K}\sum_{k=1}^{K}\sin\theta_k\right)^2} \quad ; \ 0 \le R \le 1$$

$$\ldots\ (3)$$

By construction, phase concentration R is independent of signal level and it may only assume values from the (0,1)-interval. The maximum phase concentration, R = 1, is achieved by a pure sine wave, whereas the minimum concentration, $R \approx 0$, corresponds to random noise, or a sine wave with a suitably perturbed zero-crossing pattern. Thus, the value of R increases as the sine wave becomes stronger in the received signal. It should be pointed out that phase concentration R is independent of initial phase.

When an observed signal comprises noise and a sine wave with varying amplitude A, the average value of phase concentration R will be rising from almost zero (for noise alone, i.e., A = 0) to a value close to one (for large sine-wave amplitudes and therefore large signal-to-noise ratios).

The other parameter, the envelope Z, is determined as:

$$Z = \sqrt{\left(\frac{1}{K}\sum_{k=1}^{K}X_k\right)^2 + \left(\frac{1}{K}\sum_{k=1}^{K}Y_k\right)^2} \quad ; \ Z \ge 0$$

$$\ldots\ (4)$$

In a no-noise case, the envelope Z is equal to the amplitude A of a sine wave. However, when a sine wave is corrupted by random noise, the average value of envelope Z is still equal to the amplitude A, but the observed values of Z are dispersed around A.

When noise alone is present (i.e., A = 0), observed values of Z will fluctuate randomly. In the case of Gaussian noise, the envelope Z will be characterized by a Rayleigh distribution.

In accordance with embodiments of the invention, an observed segment of a signal, which may contain a sine wave, is represented by a single point in a plane having axes corresponding to the mean level measure and the zero-crossing concordance measure, so that the position of the point in the plane is defined by the calculated values of these two measures. Thus, in the example above, the point has a position (Z, R) in a Z-R plane. Then, depending on the location of this point, a decision will be made regarding the presence or absence of a sine wave in the signal segment under examination.

For illustration purposes, Fig. 5 depicts schematically the procedure employed to represent a given signal segment by a single point in the Z-R plane. The plane, shown in Fig. 5 a), is defined by two orthogonal non-negative coordinates: envelope Z and phase concentration R.

Samples of two quadrature components of a specific segment of noise, depicted symbolically in Fig. 5 b), are represented by a single point N located in the vicinity of the origin, (Z=0, R=0). Because of the random nature of noise, a plurality of different segments of noise will produce a 'noise-alone cluster' (N-cluster) of points located close to the origin. A representation of such a cluster, containing point N, is depicted as an elliptical contour in the Z-R plane.

Samples of two quadrature components of a specific segment of a sine wave, depicted symbolically in Fig. 5 c), are represented by a single point S. The Z-coordinate of point S is equal to the amplitude A of the sine wave, whereas its R-coordinate is equal to one (maximal phase concentration).

When a sine wave is corrupted by noise, as depicted symbolically in Fig. 5 d), the point S will move to a new location P, with the value of R-coordinate less than one, and the value of Z-coordinate different, in general, from the original amplitude value A.

Because of the random nature of noise, a plurality of different segments of noise with a sine wave added will produce a 'sine-wave-and-noise cluster' (S+N-cluster) of respective points. The average value of the Z-coordinate of points in the S+N-cluster will be equal (or close) to the amplitude A; however, the average value of R-coordinate will always be less than one. A representation of such an S+N-cluster, containing point P, is depicted as another elliptical contour in the Z-R plane.

Therefore, an S+N-cluster can be reached either from a 'pure' sine-wave point S, by adding noise, or from an N-cluster, by adding a sine wave with suitable amplitude.

In embodiments of the invention, the presence of a sine wave will be declared, if an examined signal segment is represented in the Z-R plane by a point located in a 'decision' region that does not contain the N-cluster. A decision boundary is therefore constructed in order to partition the Z-R plane in a suitable manner. More particularly, based on the locations of the N-cluster and at least one S+N-cluster, a decision boundary to partition the clusters is set either manually or by computer calculation. Examples of determining a decision boundary and associated decision regions will be described in the following.

In order to facilitate the understanding of embodiments of the invention and the many resulting advantages, three examples will now be presented of N-clusters and S+N-clusters for noise having different characteristics.

In a general model of noise selected for illustrative purposes, it is assumed that the noise envelope Z has a Weibull probability distribution

$$p(z) = \frac{c}{b}\left(\frac{z}{b}\right)^{c-1}\exp\left[-\left(\frac{z}{b}\right)^c\right]; \quad b > 0, \quad c > 0 \qquad \ldots \ldots (5)$$

where b is a scale parameter and c is a shape parameter. It should be noted that when c = 2, a Weibull distribution becomes a Rayleigh distribution; also, when c = 1, a Weibull distribution becomes an exponential distribution.

Two quadrature components of noise with a Weibull envelope are obtained by assigning to each envelope value Z a phase distributed uniformly within $(-\pi,+\pi)$-interval. In the case of a Rayleigh envelope (c = 2), each of the two resulting quadrature components of noise will exhibit well-known Gaussian characteristics.

When the value of shape parameter c is less than two, the resulting quadrature components of noise will have a more 'spiky' (or impulsive) appearance than those of Gaussian noise. On the other hand, for c greater than 2, the resulting noise components are less 'spiky' than Gaussian components. In statistics, noise more spiky than Gaussian noise is often referred to as being heavy-tailed.

In the examples that follow, computer simulations were used to produce samples of quadrature components $(X_k, Y_k)$ of Weibull noise. Then, in a noise-alone case, a single value of envelope Z and a corresponding single value of phase concentration R were determined from 100 pairs $(X_k, Y_x)$. Such experiment was repeated 5000 times to produce a noise scatter-plot (N-cluster) comprising 5000 points.

Next, samples of quadrature components of a sine wave with a fixed amplitude A and random initial phase $\phi$ were suitably added to noise components. Also in this case, a single value of envelope Z and a corresponding single value of phase concentration R were determined from 100 pairs $(X_k, Y_k)$. The experiment was replicated 5000 times, and each time the initial phase of the sine wave was selected at random. One scatter-plot (S+N-cluster) was obtained for the sine-wave amplitude A = 0.3, and another one for the amplitude A = 0.8.

Impulsive Weibull model (c = 1.25)

Fig. 6 is an example of two noise components obtained from a Weibull envelope with the shape parameter c = 1.25. The parameter "b" has the effect of scaling the "Z" components of the data points and has no effect on the "R" components. The value of "b" is therefore chosen to scale the "Z" components into an appropriate range. Samples of an in-phase component are shown in Fig. 6 a), whereas samples of a quadrature component are depicted in Fig. 6 b).

Fig. 7 a) depicts a noise scatter-plot (N-cluster) in the Z-R plane. A conventional envelope detector would compare a calculated value of Z with a decision threshold comprising a Z value. For comparison purposes, this decision threshold is schematically represented in the Z-R plane of Fig. 7 a) by a vertical line. However, it is emphasised that conventional detectors do not plot points in a two-dimensional plane and instead merely compare calculated Z values with a decision threshold Z value.

As seen in Fig. 7 a), the Z-R representation used in embodiments of the present invention makes it possible to construct a decision boundary which is not limited to being a horizontal or vertical line in the Z-R plane and can instead define decision regions of any shape. Consequently, this leads to a much better discrimination between an N-cluster and a corresponding S+N-cluster.

Fig. 7 b) shows three scatter-plots representing an N-cluster (shown already separately in Fig. 7 a)) and two S+N-clusters for different values (0.3 and 0.8) of the amplitude A of added sine wave. As seen, in the case of a weak sine wave (A = 0.3), the use of a decision boundary will result in a superior detection performance in comparison to that when a conventional decision threshold based on Z alone is utilized.

Gaussian model (c = 2)

Fig. 8 is an example of two components of Gaussian noise obtained from a Rayleigh envelope (c = 2). Samples of an in-phase component are shown in Fig. 8 a), whereas samples of a quadrature component are depicted in Fig. 8 b). As seen, the noise peaks assume smaller values than those observed in the previous case, when c =1.25. As before, the parameter "b" has the effect of scaling the "Z" components of the data points and has no effect on the "R" components. The value of "b" is therefore chosen to scale the "Z" components into an appropriate range.

Fig. 9 a) depicts a noise scatter-plot (N-cluster) in the Z-R plane. A decision threshold utilized in a conventional envelope detector is represented in the Z-R plane by a vertical line, and a decision boundary is represented by a non-vertical line.

Fig. 9 b) shows three scatter-plots representing an N-cluster (shown already separately in Fig. 9 a)) and two S+N-clusters for different values (0.3 and 0.8) of the amplitude A of added sine wave.

As well known to those skilled in the art, in the case of Gaussian noise, a conventional decision threshold is thought to provide an optimal solution. Therefore, it would be thought that the use of a decision boundary different from the shown vertical line would not be justified. However, some computer experiments seem to suggest that an improvement in detection performance is possible if a two-dimensional decision boundary is used, rather than a one-dimensional decision threshold based only on Z.

Weibull model (c = 3)

Fig. 10 is an example of two noise components obtained from a Weibull envelope with the shape parameter c = 3. The parameter "b" has the effect of scaling the "Z" components of the data points and has no effect on the "R" components. The value of "b" is therefore chosen to scale the "Z" components into an appropriate range. Samples of an in-phase component are shown in Fig. 10 a), whereas samples of a quadrature component are depicted in Fig. 10 b). As seen, the noise peaks assume smaller values than those observed in the previous two cases.

Fig. 11 a) depicts a noise scatter-plot (N-cluster) in the Z-R plane. A decision threshold utilized in a conventional envelope detector is represented in the Z-R plane by a vertical line. As seen, the Z-R representation of embodiments makes it possible to construct a two-dimensional decision boundary which will lead to a much better discrimination between an N-cluster and S+N-cluster.

Fig. 11 b) shows three scatter-plots representing an N-cluster (shown already separately in Fig. 11 a)) and two S+N-clusters for different values (0.3 and 0.8) of the amplitude A of added sine wave. As seen, in the case of a weak sine wave (A = 0.3), the use of a decision boundary will result in a superior detection performance in comparison to that when a conventional decision threshold based on Z alone is utilized.

From the analysis of the above examples it follows that when a sine wave is corrupted by a non-Gaussian noise, the use of suitably constructed decision boundary will always lead to a significant improvement of detection performance.

From a theoretical viewpoint, scatter-plots used to represent N-clusters and S+N-clusters are themselves empirical representations of respective joint probability density functions of envelope Z and phase concentration R.

For illustrative purposes, Fig. 12 a) depicts the Z-R plane and two conditional joint probability density functions of envelope Z and phase concentration R:

- $p(Z,R|H_0)$, when noise alone is present
- $p(Z,R|H_1)$, when a sine wave, corrupted by noise, is present.
 Also shown is an example of a decision boundary: when a point, say, $(Z_0,R_0)$, representing an observed signal falls into the decision region above the boundary, a decision "sine wave present" is made; otherwise, a decision "noise alone present" is taken.

A decision boundary and associated decision regions can be determined by first forming the likelihood ratio L (Z,R) :

$$L(Z,R) = \frac{p(Z,R|H_1)}{p(Z,R|H_0)} \qquad \dots \dots (6)$$

Then, a decision "sine wave present" is made, when observed values of Z and R, say, $Z_0$ and $R_0$, produce the likelihood-ratio value $L(Z_0,R_0)$ that will exceed a predetermined decision threshold. The value of the decision threshold is so chosen as to obtain an acceptable probability of false alarm $P_F$.

The two required joint probability density functions: $p(Z,R|H_0)$, when noise alone is present, and $p(Z,R|H_1)$, when a noisy sine wave is present, may be determined either theoretically, or empirically via hardware or computer simulations.

For example, a probability density function of a received signal could be calculated when it is known that a signal has not been transmitted (i.e. there is no sine wave present). It would then be known that this was the probability density function of the noise alone. Similarly, when it is known that a signal has been transmitted and received, the calculated probability density function would be that of a noisy sine wave.

Fig. 12 b) illustrates the fact that the use of an envelope detector alone cannot lead to a reliable detection decision because the two probability density functions of envelope Z alone $p(Z|H_0)$ and $p(Z|H_1)$ overlap in a significant manner.

Fig. 12 c) shows that the use of a detector based on phase concentration R alone cannot lead either to a reliable detection decision because the two probability density functions of phase concentration R alone $p(R|H_0)$ and $p(R|H_1)$ also overlap in a significant manner.

A number of embodiments comprising apparatus to implement the processing described above will now be described.

First Embodiment - Dual Band-Pass Filter

Fig. 13 is a block diagram of an analogue signal detection system SDS constructed in accordance with a first embodiment of the invention. The system comprises the following blocks:

- two identical band-pass filters, BFZ and BFR
- two identical envelope detectors, EDZ and EDR
- a voltage-controlled amplifier VGA
- a hard limiter HLR
- a decision block DBK

An input band-pass signal IS is applied in parallel to a hard limiter HLR and a voltage-controlled amplifier VGA. The gain of the amplifier is set by input NL in such a way as to suitably normalize the noise level. The control signal NL is proportional to the noise level and is provided by a noise-level meter (not shown). A suitable noise-level meter is known in the art. The "noise level" NL can be any measure of noise level (e.g. rms value). The noise-level meter also determines the noise type, namely the statistical model that is the most appropriate for modelling the noise (e.g. Weibull model, Gaussian model, K-distributed model, etc.) and outputs a signal NT defining the determined noise type. In addition, the noise-level meter determines the value(s) of the noise parameter(s) associated with the determined noise type (e.g. the value of the parameter "c" for Weibull model noise) and outputs a signal (not shown) defining the determined value(s) of the noise parameter(s).

The output signal VS from the voltage-controlled amplifier VGA is filtered in a band-pass filter BFZ, whose output FZ drives an envelope detector EDZ.

The centre frequency of both the band-pass filters, BFZ and BFR, is equal to the frequency of a sine wave to be detected. As known to those skilled in the art, the bandwidth of the filters should be inversely proportional to the duration of a signal segment to be processed.

The output HS of the hard limiter HLR is filtered in a band-pass filter BFR, whose output FH drives an envelope detector EDR.

The envelope detectors EDZ and EDR act to condition their input signals as required by the decision block DBK. For example, if the decision block DBK requires a digital input signal, then EDZ and EDR would perform an analogue-to-digital conversion. EDZ and EDR could also perform, for example, a sampling operation, accumulating operation and/or calculating operation, as required.

The system SDS may be viewed as comprising one linear channel and one non-linear channel which incorporates the hard limiter HLR. In the linear channel, the band-pass filter BFZ extracts from an input signal VS a sinusoidal component FZ whose amplitude is indicative of the amplitude of a sine wave (if present) corrupted by noise. An output value ZZ of the envelope detector EDZ is a measure of this amplitude. The determined value ZZ is independent of the phase of the extracted sinusoidal component FZ.

In the non-linear channel, an input signal IS is converted by the hard limiter HLR into a bipolar rectangular waveform HS of unit amplitude. The transition (switching) times between the two levels, +1 and -1, reproduce faithfully the zero-crossing pattern of the input signal IS. Accordingly, all amplitude information contained in the input signal IS has been discarded, and the 'time' information of interest has been retained.

The band-pass filter BFR extracts now from an input signal HS a single sinusoidal component FH. Its amplitude is indicative of the concordance of the zero-crossing pattern of the input signal IS with a uniform pattern exhibited by a sinusoidal waveform having a frequency equal to the centre frequency of the band-pass filter BFR. An output value RR of the envelope detector EDR is a measure of the concordance of the two patterns. The determined value RR is independent of the amplitude of the input signal IS. Moreover, the value RR does not depend on the phase of the extracted sinusoidal component FH.

The outputs, ZZ and RR, of the respective envelope detectors represent the envelope Z and phase concentration R, respectively, and are applied to the decision block DBK together with the signal NT indicative of the type of noise (e.g., Weibull, Gaussian, K-distributed, etc.) and the signal (not shown) defining the value(s) of the required parameter (s) of the noise.

The decision block DBK contains a library of pre-calculated decision boundaries, each decision boundary corresponding to a different combination of noise type and noise parameter(s). Thus, for example, decision boundaries as shown in Figures 7 b), 9 b) and 11 b) may be pre-calculated and pre-stored in decision block DBK. In dependence upon the noise type alone or both the noise type and the value(s) of the noise parameter(s) determined for the received signal, decision block DBK selects one of the pre-stored decision boundaries. The decision block DBK then processes jointly signals appearing at inputs ZZ, RR to produce a binary decision DD: "noise alone present" or "a noisy sine wave present" in dependence upon the selected decision boundary.

As noted above, the centre frequency of the band-pass filters BFZ and BFR in this embodiment are equal to the frequency of the sine wave to be detected. Accordingly, if sine waves of more than one frequency are to be detected, or if the frequency of the sine wave to be detected is unknown, then multiple receiving channels will need to be provided, each receiving channel comprising a respective signal detecting system SDS with band-pass filters having a different centre frequency to the centre frequency of the band-pass filters in other channels.

It should be noted that many existing detection systems employing band-pass filters can be improved by incorporating some parts of this embodiment.

Second Embodiment - Dual Quadrature Receiver

Fig. 14 is a block diagram of another analogue signal detection system SDS constructed in accordance with a second embodiment of the invention. The system incorporates two identical quadrature receivers, QRZ and QRR; the receiver QRZ is driven by a signal VS supplied by a voltage-controlled amplifier VGA, whereas the receiver QRR is driven by a signal HS provided by a hard-limiter HLR. Both the voltage-controlled amplifier VGA and the hard limiter HLR are driven in parallel by an input signal IS.

The gain of the voltage-controlled amplifier VGA is set by input NL in such a way as to normalize the noise level. The control signal NL is proportional to the noise level and is provided by a suitable noise-level meter (not shown), as described earlier. The noise level meter also supplies a signal NT defining the determined type of the noise and a signal (not shown) defining the value(s) of the parameter(s) associated with the determined type of noise, as described earlier.

Each of the two identical quadrature receivers, QRZ and QRR, comprises the following blocks:

- two mixers (or multipliers), MXI and MXQ
- two low-pass filters, LPI and LPQ
- two signal conditioning units, EDI and EDQ
- a 'Pythagoras circuit' PYT

The functions and operations of the receiver QRZ are as follows. An input signal VS is applied in parallel to two mixers, MXI and MXQ. The other inputs of the mixers are driven in a usual way by sinusoidal and co-sinusoidal waveforms supplied by a conventional local oscillator.

The outputs, PI and PQ, of the respective mixers are filtered in the low-pass filters LPI and LPQ to produce two output signals LI and LQ. Those two signals are first converted to suitable forms, MI and MQ, in two signal conditioning units, EDI and EDQ, which condition the signals in accordance with the requirements of the "Pythagoras circuit" PYT. Then, the 'Pythagoras circuit' PYT is employed to produce a signal ZZ being a representation of the quantity $\sqrt{LI^2 + LQ^2}$ and corresponding to the envelope Z.

The functions and operations of the other receiver QRR are the same as described above. However, in this case, the output of the 'Pythagoras circuit' is a signal RR, corresponding to the phase concentration R.

The outputs, ZZ and RR, of the respective 'Pythagoras circuits' are applied to the decision block DBK together with the signal NT indicative of the type of noise (e.g., Weibull, Gaussian, K-distributed, etc.) and also the signal (not shown) defining the value(s) of the required parameter(s) of the noise. The decision block DBK processes jointly signals appearing at inputs ZZ, RR and NT to produce a binary decision DD: "noise alone present" or "a noisy sine wave present".

More particularly, as described in the first embodiment, the decision block DBK contains a library of pre-calculated decision boundaries, each decision boundary corresponding to a different combination of noise type and noise parameter(s). Thus, for example, decision boundaries as shown in Figures 7 b), 9 b) and 11 b) may be pre-calculated and pre-stored in decision block DBK. In dependence upon the noise type alone or both the noise type and the value(s) of the noise parameter(s) determined for the received signal, decision block DBK selects the most appropriate pre-stored decision boundary. The decision block DBK then compares the point defined by the input signals ZZ and RR to the selected decision boundary to produce the binary decision DD.

The main advantage of the dual quadrature receiver of the second embodiment described above is its ability to modify the expected frequency of a sine wave to be detected by varying the frequency of a local oscillator. In this way, the multiple channels of the first embodiment are avoided.

It should be noted that many existing detection systems employing quadrature receivers can be improved by incorporating some parts of this embodiment.

Third Embodiment - Composite Matched Filter

In many practical applications, a sine wave to be detected has a form of a pulse with sinusoidal carrier. The pulse duration is usually known (at least approximately) but its time of arrival is in general unknown. A suitable detection system is, in this case, a matched filter. Such a filter is known to exhibit good detection characteristics so long as the corrupting noise is Gaussian.

Fig. 15 is a block diagram of a digital composite matched filter CMF constructed in accordance with a third embodiment of the invention. The system comprises the following blocks:

- two shift registers, RGX and RGY, each comprising K respectively cells, X1, X2, ... , XK and Y1, Y2, ... , YK
- two arithmetic blocks, AB1 and AB2
- four adders, ADX, ADY, ADC and ADS
- four accumulators, ACX, ACY, ACC and ACS
- a decision unit DCU

The composite matched filter CMF operates as follows. Digital samples IX and IY that represent two quadrature components of a signal being processed are supplied by suitable analogue-to-digital converters at a rate equal to the frequency of clock pulses appearing at input CK. The inputs, IX and IY, could have been generated, for example, by sampling one of the signal pairs (LI, LQ) shown in Figure 14. Other appropriate methods of generating digital samples of two quadrature components of a signal are known in the art. A stream of digital samples IX is shifted continually into the register RGX. Accordingly, the K cells, X1, X2, ... , XK, of the register RGX will store, at any time instant, the K latest samples received at input IX.

In a similar fashion, a stream of digital samples IY is shifted continually into the register RGY, and the K cells, Y1, Y2, ... , YK, of the register RGY will store, at any time instant, the K latest samples received at input IY. Therefore, the operation of the two shift registers, RGX and RGY, may be viewed as being equivalent to moving concurrently and in parallel two corresponding 'data windows' along two streams of digital samples.

The number K of cells used in both the shift registers, RGX and RGY, is chosen in such a way that the product of K and the clock period is equal to the duration of an expected sinusoidal pulse.

The operation of the composite matched filter CMF is initiated by setting to zero the states of all the four accumulators, ACX, ACY, ACC and ACS. This task is performed by a 'reset' pulse RT produced by the decision unit DCU and applied to inputs RT of the four accumulators. It is also convenient, although not necessary, to set to zero the initial states of the shift registers, RGX and RGY.

The accumulator ACX provides at its output SX the sum of K samples stored at any time instant in the shift register RGX; hence

$$\text{state of ACX} \;=\; X1 + X2 + ... + XK \quad .... \;(7)$$

In order to avoid using all K outputs of the K cells, the above summing operation is arranged in the following manner.

At each time instant, the accumulator ACX 'adjusts' its state by subtracting the sample XK just leaving the register RGX and adding a sample IX just entering the register RGX. Accordingly, the adder ADX forms the difference DX between sample IX appearing at input FX and sample XK appearing at input LX; this difference DX is added to the current state of the accumulator ACX.

In a no-noise case, for first K samples appearing at input IX, the adder ADX will reproduce these values at its output DX, since only zero-valued samples are leaving the shift register RGX. Then, the adder ADX will start producing differences between samples entering and leaving the shift register RGX.

In a similar fashion, the accumulator ACY provides at its output SY the sum of K samples stored at any time instant in the shift register RGY; hence

$$\text{state of ACY} = Y1 + Y2 + \ldots + YK \quad \ldots (8)$$

The accumulator ACY is driven by a value DY provided the adder ADY. The value DY is the difference between sample IY appearing at input FY and sample YK appearing at input LY.

The outputs, SX and SY, of the respective accumulators, ACX and ACY, can be used to determine the representation of the envelope Z of a signal being processed

$$Z = \sqrt{(SX/K)^2 + (SY/K)^2} \quad \ldots (9)$$

Therefore, this part of the composite matched filter CMF can be regarded as a conventional matched filter.

In order to avoid using additional shift registers for storing sines and cosines, two arithmetic blocks, AB1 and AB2, are employed. The arithmetic block AB1 provides at its outputs FC and FS, respectively, the value of the cosine and the sine determined from samples IX and IY. Similarly, the arithmetic block AB2 provides at its outputs LC and LS, respectively, the value of the cosine and the sine determined from samples XK and YK.

The accumulator ACC provides at its output SC the sum of K cosines calculated from K sample pairs

$$(X1,Y1), (X2,Y2), \ldots , (XK,YK)$$

stored at any time instant in the shift registers RGX and RGY. Hence,

$$\text{state of ACC} = \cos \theta 1 + \cos \theta 2 + \ldots + \cos \theta K \quad \ldots (10)$$

where $\theta k = \arctan(Yk/Xk)$, $k = 1, 2, \ldots , K$, and $\arctan(\cdot)$ is a four-quadrant operation.

The accumulator ACC is driven by a value DC provided by the adder ADC. The value DC is the difference between two values, FC and LC, supplied respectively by the arithmetic blocks AB1 and AB2.

In a similar fashion, the accumulator ACS provides at its output SS the sum of K sines calculated from K sample pairs

$$(X1,Y1), (X2,Y2), \ldots , (XK,YK)$$

stored at any time instant in the shift registers RGX and RGY. Hence,

$$\text{state of ACS} = \sin \theta 1 + \sin \theta 2 + \ldots + \sin \theta K \quad \ldots (11)$$

where $\theta k = \arctan(Yk/Xk)$, $k = 1, 2, \ldots , K$, and $\arctan(\cdot)$ is a four-quadrant operation.

The accumulator ACS is driven by a value DS provided by the adder ADS. The value DS is the difference between two values, FS and LS, supplied respectively by the arithmetic blocks AB1 and AB2.

The outputs, SC and SS, of the respective accumulators, ACC and ACS, can be used to determine the representation of the phase concentration R of a signal being processed

$$R = \sqrt{(SC/K)^2 + (SS/K)^2} \qquad \dots \ (12)$$

Therefore, this part of the composite matched filter CMF may be referred to as a co-matched filter.

The decision unit DCU utilizes values appearing continually at its inputs SX, SY, SC and SS to determine the envelope Z and the phase concentration R of a sequence of K sample pairs

$$(X1,Y1), (X2,Y2), \dots , (XK,YK)$$

stored at any time instant in the shift registers RGX and RGY.

As in the first and second embodiments, the decision unit DCU contains a library of pre-calculated decision boundaries, each decision boundary corresponding to a different combination of noise type and noise parameter(s). Thus, for example, decision boundaries as shown in Figures 7 b), 9 b) and 11 b) may be pre-calculated and pre-stored in decision unit DCU. In dependence upon the noise type alone or both the noise type and the value(s) of the noise parameter(s) determined for the received signal, decision unit DCU selects one of the pre-stored decision boundaries. The decision unit DCU then processes jointly all values appearing at inputs SX, SY, SS and SC to produce a binary decision DD based on the selected decision boundary: "noise alone present" or "a noisy sine wave present".

Fourth Embodiment - Operation of a Composite Matched Filter in K-distributed noise

A fourth embodiment of the present invention will now be described, in which the component are the same as those in the third embodiment, but the embodiment additionally stores one or more decision boundaries so as to perform signal detection in K-distributed noise.

K-distributed noise, representing another non-Gaussian noise model, is useful in characterizing electromagnetic signals scattered from complex surfaces. The probability density function p(z) of the envelope of K-distributed noise is given by

$$p(z) = \frac{2b}{\Gamma(v)} \left(\frac{bz}{2}\right)^v K_{v-1}(bz) \qquad \dots \ (13)$$

where z is the noise envelope, b is a scale parameter, v is a shape parameter, and $K_{v-1}(\cdot)$ is a modified Bessel function of the second kind. In practical applications, the shape parameter v assumes values ranging from 0.1 (for extremely 'spiky' impulsive noise) to 20, corresponding approximately to Gaussian noise. K-distributed noise is discussed in more detail in: E. B. Rockower: Quantum derivation of K-distributed noise for finite <N>. J. Opt. Soc. Am. A ., Vol. 5, May 1985, pp 730-734.

Two quadrature components of K-distributed noise were obtained by assigning to each envelope value Z a phase distributed uniformly within (-π,+π)-interval.

Computer simulations were used to produce samples of quadrature components (Xk, Yk) of K-distributed noise with shape parameter v = 0.5. Samples of an in-phase component are shown in Fig. 16 a), whereas samples of a quadrature component are depicted in Fig. 16 b). As seen, the magnitude of noise peaks can exceed the value of 8; hence, in this case, noise is even more impulsive that that obtained above from a Weibull model with shape parameter c = 1.25. The value of "b" only scales the "z" component of the data and is chosen to provide a range of "z" components of the data.

In a noise-alone case, a single value of envelope Z and a corresponding single value of phase concentration R were determined from 100 pairs (Xk, Yk). Such experiment was repeated 15,000 times to produce a noise scatter-plot (N-cluster) shown in Fig. 17 a). A decision boundary of a composite matched filter is also shown.

Next, samples of quadrature components of a sine wave with a small amplitude A = 0.35 and random initial phase were suitably added to the noise components. Also in this case, a single value of envelope Z and a corresponding single value of phase concentration R were determined from 100 pairs $(X_k, Y_k)$. The experiment was replicated 15,000 times, and each time the initial phase of the sine wave was selected at random.

Fig. 17 b) shows a corresponding scatter-plot (S+N-cluster) along with the decision boundary. The position of this scatter-plot with respect to the decision boundary indicates that a conventional matched filter, utilizing only the envelope Z, will provide detection performance inferior to that offered by a composite matched filter.

**Modifications and Variations**

Many modifications and variations can be made to the processing operations described above and the apparatus for carrying out the processing operations.

For example, in the processing described above, the mean level measure is calculated as the envelope Z in accordance with equation (4) above. However, other mean level measures may be used instead. For example, if $s_m$, m= 1, 2, ..., M, are samples of a zero-mean signal, then a suitable alternative mean level measure, $Z_d$, is:

$$Z_d = \left( \frac{1}{M} \sum_{m=1}^{M} |s_m|^d \right)^{1/d} \qquad \dots \ (14)$$

When d=1, $Z_1$ is just the mean absolute value; when d=2, $Z_2$ is a conventional rms value; when d>2, $Z_d$ is indicative of the signal level associated with its "generalized" power (the concept of a so-called "generalized power" is well-known to a skilled person).

Similarly, in the processing described above, the zero-crossing concordance measure is calculated as the phase concentration R in accordance with equation (3) above. This form of zero-crossing concordance measure has the advantage that its value increases as the strength of the sinusoidal waveform in the received signal increases. In this way, the values of both the mean level measure and the zero-crossing concordance measure move in the same direction. However, other zero-crossing concordance measures may be used instead. By way of a first example, a circular range can be used as the zero-crossing concordance measure, where the circular range is the length of the smallest circular arc which contains all, or a substantial portion of, the phase observations. One way of calculating a circular range is to calculate $\theta_k$ for each sample pair using equations (2) above, thereby defining points $\theta_1, ..., \theta_K$ lying on a unit circle in the range $0 \leq \theta_k \leq 2\pi$, k = 1,2, ....., K. Let $\theta_{(1)} \leq ... \leq \theta_K$ be the linear order statistics of $\theta_1, ..., \theta_K$. The are lengths between adjacent observations are:

$$T_k = \theta_{(k+1)} - \theta_{(k)}, \quad k = 1, ..., K-1; \qquad T_K = 2\pi - \theta_{(K)} + \theta_{(1)} \qquad \dots \ (15)$$

The circular range, $\omega$, is then given:

$$\omega = 2\pi - \max(T_1, ..., T_K) \qquad \dots \ (16)$$

By way of a second example, a circular mean difference, $\overline{D}o$, can be used as the zero-crossing concordance measure, where $\overline{D}o$ represents the mean distance between pairs of data points and is given by:

$$\overline{D}o = \frac{1}{K^2} \sum_{k=1}^{K} \sum_{j=1}^{K} \left\{ \pi - |(\pi - |\theta_k - \theta_j|)| \right\} \qquad \dots \ (17)$$

By way of further examples, a measure of circular variance, V, circular dispersion, $\hat{\delta}$, or circular standard

deviation, ν, based on the calculated phase concentration R may be used as the zero-crossing concordance measure. For example, the following may be used:

$$V = 1 - R \qquad \qquad .... \ (18)$$

$$\hat{\delta} = \frac{1 - R_2}{2R^2} \qquad \qquad .... \ (19)$$

$$\upsilon = \left\{ -2 \log R \right\}^{1/2} \qquad \qquad .... \ (20)$$

where the quantity $R_2$ in equation (19) is determined from equation (3) when $\cos \theta_k$ and $\sin \theta_k$ are replaced, respectively, with $\cos 2\theta_k$ and $\sin 2\theta_k$.

These and other measures of phase dispersion/concentration are discussed in more detail in: K. V. Mardia and P.E. Jupp "Directional Statistics", Wiley, New York 2000, pp. 17-20.

Of course, the skilled person will realise that other measures of phase dispersion/concentration can be employed as the zero-crossing concordance measure.

For example, when signal-to-noise ratio is large (or at least, moderate), a conventional (linear) standard deviation can be employed as a measure of phase dispersion. Although not optimal for circular observations, it can still provide a useful measure of the zero-crossing discordance and is consequently a useful zero-crossing concordance measure.

In the first and second embodiments described above, a hard limiter can be replaced with a device having an output-input characteristic of a sigmoid form (one kind of a 'soft' limiter). As well known to those skilled in the art, a class of sigmoid functions include: a hyperbolic tangent, an arctangent, generalized logistic function and many others.

In the embodiments described above, the decision blocks DBK and decision unit DCU each store a library of pre-calculated decision boundaries, and select a decision boundary to be used for a particular input signal in dependence upon the noise type in the input signal or both the noise type and the value(s) of the associated noise parameter(s) in the input signal. However, instead, the decision blocks DBK and decision circuit DCU may calculate the decision boundary in real-time.

It should be noted that the concept of the zero-crossing concordance measure utilized in the invention can also be exploited to improve the performance of many existing systems, including those processing signals being combinations of sinusoidal components. In such applications, some suitable form of spectral analysis may be used to determine individual sinusoidal components of a composite signal under examination.

The foregoing description of preferred embodiments of the invention has been presented for the purpose of illustration and description. It is not intended to be exhaustive or to limit the invention to the precise form disclosed. In light of the foregoing description, it is evident that many alterations, modifications, and variations will enable those skilled in the art to utilize the invention in various embodiments suited to the particular use contemplated.

**Claims**

**1.** A signal processing method, comprising:

processing a received signal to calculate a first value comprising a measure of the mean level of the signal and a second value comprising a measure of the concordance of a zero-crossing pattern of the signal with a uniform pattern exhibited by a sinusoidal waveform having a frequency equal to the centre frequency of the signal;
defining a point in a plane, the position of the point being determined by the calculated first and second value;
comparing the position of the point with a boundary line in the plane; and
determining whether the received signal contains a sinusoidal waveform in dependence upon the result of the comparison.

**2.** A method according to Claim 1, wherein the step of processing the received signal to calculate the first and second values comprises:

splitting the received signal into first and second signals; and
processing the first and second signals to generate the first and second values.

**3.** A method according to Claim 2, wherein the step of processing the first and second signals to generate the first and second values comprises:

sampling the first and second signals at a plurality of time instants to generate a respective pair of sample values for each time instant; and
processing the pairs of sample values to generate the first and second values.

**4.** A method according to Claim 2 or Claim 3, wherein the received signal is split into first and second signals comprising quadrature components of the received signal.

**5.** A method according to any preceding claim, wherein, in the step of comparing the position of the point with the boundary line, the position of the point is compared with a boundary line which is not a straight line in the plane.

**6.** A method according to any preceding claim, wherein the method further comprises:

processing the received signal to determine a type of noise present in the signal; and
selecting a boundary line to be used in the comparing step from a plurality of different pre-stored boundary lines in dependence upon the determined type of noise.

**7.** A method according to Claim 6, wherein:

the method further comprises processing the received signal to determine at least one parameter value for the determined type of noise; and
the boundary line to be used in the comparing step is selected in dependence upon both the determined type of noise and the determined parameter value(s).

**8.** Signal processing apparatus, comprising:

means for processing a received signal to calculate a first value comprising a measure of the mean level of the signal and a second value comprising a measure of the concordance of a zero-crossing pattern of the signal with a uniform pattern exhibited by a sinusoidal waveform having a frequency equal to the centre frequency of the signal;
means for defining a point in a plane, the position of the point being determined by the calculated first and second values;
means for comparing the position of the point with a boundary line in the plane; and
means for determining whether the received signal contains a sinusoidal waveform in dependence upon the result of the comparison.

**9.** Apparatus according to Claim 8, wherein the means for processing the received signal to calculate the first and second values comprises:

means for splitting the received signal into first and second signals; and
means for processing the first and second signals to calculate the first and second values.

**10.** Apparatus according to Claim 9, wherein the means for processing the first and second signals to calculate the first and second values comprises:

means for sampling the first and second signals at a plurality of time instants to generate a respective pair of sample values for each time instant; and
means for processing the pairs of sample values to generate the first and second values.

**11.** Apparatus according to Claim 9 or Claim 10, wherein the means for splitting the received signal is arranged to split the received signal into first and second signals comprising quadrature components of the received signal.

12. Apparatus according to any of Claims 8 to 11, wherein the means for comparing the position of the point with a boundary line is arranged to compare the position of the point with a boundary line that is not a straight line in the plane.

13. Apparatus according to any of Claims 8 to 12, wherein the apparatus further comprises:

means for processing the received signal to determine a type of noise present in the signal; and
means for selecting a boundary line to be used in the comparing process from a plurality of different pre-stored boundary lines in dependence upon the determined type of noise.

14. Apparatus according to Claim 13, wherein:

the apparatus further comprises means for processing the received signal to determine at least one parameter value for the determined type of noise; and
the means for selecting the boundary line is arranged to select the boundary line in dependence upon both the determined type of noise and the determined parameter value(s).

$p(W|H_0)$ $p(W|H_1)$

$P_D$

$W$

$0$

decision
threshold

$P_F$

FIG. 1

QRV

IS → MXI → PI → LPI → LI → EDI

$cos\ 2\pi f_0\ t$

IS →

$sin\ 2\pi f_0\ t$

IS → MXQ → PQ → LPQ → LQ → EDQ

MI → PYT → ES → DBK → DD

MQ

DT

PRIOR ART

FIG. 2

IS → BPF → FH → EDR → ES → DBK → DD

DT

PRIOR ART

FIG. 3

DFR

IS → HLR → HS → BPF → FH → EDR → ES → DBK → DD

DT

PRIOR ART

FIG. 4

b)

samples of noise components

c)

samples of sine-wave components

a)

phase concentration R

Z-R plane

decision boundary

sine wave added

N cluster

envelope Z

noise added

S+N cluster

d)

samples of components
of a sine wave corrupted
by noise

FIG. 5

FIG. 6

FIG. 7

a)

amplitude

in-phase component

sample number

b)

amplitude

quadrature component

sample number

FIG. 8

a)

b)

FIG. 9

FIG. 10

FIG. 11

FIG. 12

FIG. 13

FIG. 14

FIG. 15

a)

b)

FIG. 16

a)

b)

FIG. 17

Europäisches
Patentamt

European
Patent Office

Office européen
des brevets

# EUROPEAN SEARCH REPORT

**Application Number**

EP 08 17 0389

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2008/042506 A (TEKTRONIX INC [US]; TAN KAN [US]; PICKERD JOHN J [US]) 10 April 2008 (2008-04-10) * figures 1,2,4,5,6a-7b,8 * * paragraphs [0004], [0006] * * paragraph [0014] - paragraph [0016] * * paragraph [0021] - paragraph [0023] * ----- | 1-14 | INV. G01R19/25 |
| A | US 3 927 260 A (AMUNDSON ROBERT M ET AL) 16 December 1975 (1975-12-16) * figure 1 * * column 1, line 5 - line 12 * * column 4, line 29 - column 8, line 12 * * column 13, line 15 - line 40 * * column 18, line 60 - column 19, line 7 * ----- | 1-14 | |
| A | EP 1 903 557 A (AVAYA TECH LLC [US]) 26 March 2008 (2008-03-26) * paragraph [0001] * * paragraph [0010] - paragraph [0012] * ----- | 1-14 | |
| A | YOUNG-IK KIM ET AL: "Estimation of Interaural Time Differences Based on Zero-Crossings in Noisy Multisource Environments" IEEE TRANSACTIONS ON AUDIO, SPEECH, AND LANGUAGE PROCESSING, IEEE SERVICE CENTER, NEW YORK, NY, US, vol. 15, no. 2, 1 February 2007 (2007-02-01), pages 734-743, XP011157509 ISSN: 1558-7916 * the whole document * ----- -/-- | 1-14 | **TECHNICAL FIELDS SEARCHED (IPC)** G01R |

The present search report has been drawn up for all claims

| Place of search | Date of completion of the search | Examiner |
|---|---|---|
| Berlin | 28 April 2009 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 08 17 0389

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KEMAN LIU ET AL: "A statistical method for underwater target detection" INTELLIGENT CONTROL AND AUTOMATION, 2008. WCICA 2008. 7TH WORLD CONGRESS ON, IEEE, PISCATAWAY, NJ, USA, 25 June 2008 (2008-06-25), pages 5878-5882, XP031300796 ISBN: 978-1-4244-2113-8 * the whole document * | 1-14 | |
| A | EP 1 669 764 A (TEKTRONIX INC [US]) 14 June 2006 (2006-06-14) * figure 3 * * paragraph [0018] * | 1,8 | |
| A | US 3 238 457 A (BOYMEL BERNARD R ET AL) 1 March 1966 (1966-03-01) * column 1, line 8 - column 2, line 42 * | 1-14 | |
| A | TOMOMI MURAKAMI ET AL: "Detection of Asymmetric Sideband Signals in the Presence of Noise" IRE TRANSACTIONS ON BROADCAST AND TELEVISION RECEIVERS, IEEE, U.S.A, vol. BTR-1, no. 1, 1 January 1959 (1959-01-01), pages 46-75, XP011212373 ISSN: 0096-1655 * the whole document * | 1-14 | TECHNICAL FIELDS SEARCHED (IPC) |

The present search report has been drawn up for all claims

| Place of search | Date of completion of the search | Examiner |
|---|---|---|
| Berlin | 28 April 2009 | Höller, Helmut |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 08 17 0389

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2009

| Patent document cited in search report | | Publication date | Patent family member(s) | | Publication date |
|---|---|---|---|---|---|
| WO 2008042506 | A | 10-04-2008 | US | 2008082278 A1 | 03-04-2008 |
| US 3927260 | A | 16-12-1975 | NONE | | |
| EP 1903557 | A | 26-03-2008 | CN | 101202040 A | 18-06-2008 |
| | | | JP | 2008077088 A | 03-04-2008 |
| | | | KR | 20080026073 A | 24-03-2008 |
| | | | US | 2008071531 A1 | 20-03-2008 |
| EP 1669764 | A | 14-06-2006 | JP | 2006186994 A | 13-07-2006 |
| | | | US | 2006129355 A1 | 15-06-2006 |
| US 3238457 | A | 01-03-1966 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2004097452 A

### Non-patent literature cited in the description

- **E. B. Rockower.** Quantum derivation of K-distributed noise for finite <N>. *J. Opt. Soc. Am. A .,* May 1985, vol. 5, 730-734

- **K. V. Mardia ; P.E. Jupp.** Directional Statistics. Wiley, 2000, 17-20